(19) **Europäisches Patentamt**
European Patent Office
Office européen des brevets

(11) **EP 2 052 360 B1**

(12) **EUROPÄISCHE PATENTSCHRIFT**

(45) Veröffentlichungstag und Bekanntmachung des Hinweises auf die Patenterteilung:
**05.10.2011 Patentblatt 2011/40**

(21) Anmeldenummer: **07785677.1**

(22) Anmeldetag: **25.07.2007**

(51) Int Cl.:
*G06T 5/00* (2006.01)    *H01J 37/26* (2006.01)

(86) Internationale Anmeldenummer:
**PCT/DE2007/001314**

(87) Internationale Veröffentlichungsnummer:
**WO 2008/019644 (21.02.2008 Gazette 2008/08)**

(54) **VERFAHREN UND ELEKTRONENMIKROSKOP ZUR MESSUNG DER ÄHNLICHKEIT ZWEIDIMENSIONALER BILDER**

METHOD AND ELECTRON MICROSCOPE FOR MEASURING THE SIMILARITY OF TWO-DIMENSIONAL IMAGES

PROCEDE ET MICROSCOPE ELECTRONIQUE POUR MESURER LA SIMILITUDE D'IMAGES EN DEUX DIMENSIONS

(84) Benannte Vertragsstaaten:
**AT BE BG CH CY CZ DE DK EE ES FI FR GB GR HU IE IS IT LI LT LU LV MC MT NL PL PT RO SE SI SK TR**

(30) Priorität: **16.08.2006   DE 102006038211**

(43) Veröffentlichungstag der Anmeldung:
**29.04.2009   Patentblatt 2009/18**

(73) Patentinhaber: **Forschungszentrum Jülich GmbH 52425 Jülich (DE)**

(72) Erfinder:
• **THUST, Andreas 50939 Köln (DE)**
• **BARTHEL, Juri 41812 Erkelenz (DE)**

(56) Entgegenhaltungen:
**EP-A- 1 037 253**

• **GONZALES, R.C., WOODS, R.E.: "Digital Image Processing" 2002, PRENTICE HALL , XP007903260 Seite 701, letzter Absatz - Seite 704, Absatz 1**
• **ZEMLIN, J., ZEMLIN, F.: "Diffractogram tableaux by mouse click" ULTRAMICROSCOPY, Bd. 93, Nr. 1, 2002, - 2002 Seiten 77-82, XP007903133 in der Anmeldung erwähnt**
• **FAULKNER H M L ET AL: "Computational aberration determination and correction" OPTICS COMMUNICATIONS, NORTH-HOLLAND PUBLISHING CO. AMSTERDAM, NL, Bd. 216, Nr. 1-3, 1. Februar 2003 (2003-02-01), Seiten 89-98, XP004404786 ISSN: 0030-4018**

**Beschreibung**

Die Erfindung betrifft ein Verfahren zur Messung der Ähnlichkeit von zweidimensionalen Bildern sowie ein Elektronenmikroskop zur Durchführung des Verfahrens.

Stand der Technik

In einem Transmissionselektronenmikroskop wird ein Elektronenstrahl auf das zu betrachtende Objekt gerichtet und nach dem Durchqueren des Objekts mittels elektromagnetischer Linsen zur Abbildung gebracht. Analog zu Linsen für sichtbares Licht weisen elektromagnetische Linsen zur Ablenkung von Elektronen Abbildungsfehler auf, die das Auflösungsvermögen des Mikroskops verschlechtern können. Derartige Abbildungsfehler werden Aberrationen genannt. Bei herkömmlichen elektromagnetischen Rundlinsen ist die sogenannte sphärische Aberration der bei weitem stärkste Abbildungsfehler. Neben der sphärischen Aberration gibt es eine Vielzahl weiterer Aberrationen, die nach verschiedenen mathematischen Systemen kategorisiert werden können. So treten neben Defokussierung und Astigmatismus, die in der Augenoptik in den Begriffen Kurz/Weitsichtigkeit sowie Stabsichtigkeit ihr Analog finden, viele weitere Aberrationen auf, wie zum Beispiel axiale Koma, drei-, vier-, fünf- und sechszähliger Astigmatismus, Stemfehler, Dreilappfehler sowie andere mehr. Die Anzahl, bzw. Ordnung der Aberrationen, die bei einem Transmissionselektronenmikroskop eine signifikante Rolle in Bezug auf die Abbildungsqualität spielen, steigt mit zunehmendem Auflösungsvermögen des Mikroskops. Die Kenntnis bzw. die Korrektur von Aberrationen spielt bei modernen Transmissionselektronenmikroskopen, deren Auflösungsvermögen knapp über oder sogar unter 0.1 Nanometer liegt, eine entscheidende Rolle.

Um Aberrationen eines Transmissionelektronenmikroskops bestimmen zu können, wird in der Regel die Kipptableau- oder Zemlin-Methode (F. Zemlin et al., "Coma-free alignment of high resolution electron microscopes with the aid of optical diffractograms", Ultramicroscopy 3, 49-60 (1978)) angewandt. Hierbei werden Bilder einer dünnen amorphen Objektstelle unter verschiedenen Verkippungen des einfallenden Elektronenstrahls aufgenommen und die effektive Defokussierung sowie der effektiv vorhandene Astigmatismus für jedes einzelne Bild der Kippserie bestimmt. Effektiv vorhandene Defokussierung und Astigmatismus als niedrigste Ordnungen von Aberrationen werden durch die höheren Ordnungen von Aberrationen induziert und es ist daher möglich, aus den zur Kippserie gehörenden Defokussierungs- und Astigmatismuswerten die gewünschten unbekannten Aberrationen höherer Ordnung zu bestimmen.

Bei herkömmliche Elektronenmikroskopen, die ausschließlich aus elektromagnetischen Rundlinsen bestehen, ist es zwar möglich, mittels der beschriebenen Kipptableau-Methode eine Vielzahl von Aberrationen zu bestimmen, die Anzahl der korrigierbaren Aberrationen ist jedoch auf Defokussierung, zwei- und dreizähligen Astigmatismus sowie axiale Koma beschränkt. Insbesondere lässt sich bei einem mit Rundlinsen ausgestatteten Mikroskop die stark dominierende sphärische Aberration zwar bestimmen, aber nicht korrigieren.

Zur Steigerung des Auflösungsvermögens ist aus (S. Uhlemann, M. Haider: "Residual wave aberrations in the first spherical aberration corrected transmission electron microscope", Ultramicroscopy 72, 109-119 (1998)) ein Elektronenmikroskop mit einem Korrektor für die sphärische Aberration bekannt. Dieser Korrektor beinhaltet neben Rundlinsen zwei elektromagnetische Hexapole, die es erlauben, die sphärische Aberration zu kompensieren. Um den Korrektor, der selbst wiederum ungewollt eine Vielzahl zusätzlicher Aberrationen erzeugen kann, überhaupt justieren und im gewünschten Sinne benutzen zu können, werden die zunächst noch unbekannten Aberrationen ebenfalls mit der Kipptableau-Methode bestimmt. Anschließend können insbesondere die auf diese Weise bestimmte sphärische Aberration sowie einige weitere Aberrationen durch korrekte Justage des Hardware-Korrektors schon bei der Bildaufnahme kompensiert werden. Auch hier kommt der Bestimmung von Aberrationen mittels Defokussierungs- und Astigmatismusmessungen eine ganz entscheidende Rolle zu.

Zur Bestimmung von Defokussierung und Astigmatismus eines experimentell aufgenommenen Bildes einer dünnen amorphen Objektstelle wird dessen Fourierraumdarstellung erstellt. Diese Fourierraumdarstellung, die auch Diffraktogramm genannt wird, weist ein für die jeweilige Defokussierung und den jeweiligen Astigmatismus typisches Streifenmuster auf. Ziel ist es dann, das Streifenmuster quantitativ zu erfassen und ihm eindeutig und möglichst genau Defokussierungs- und Astigmatismuswerte zuordnen zu können.

Zur Erkennung des Streifenmusters wird eine Vielzahl von möglichen Diffraktogrammen berechnet, die sich in Defokussierung und Astigmatismus unterscheiden. Diese berechneten Diffraktogramme werden dann entweder visuell per Auge oder maschinell mit dem experimentell erhaltenen Diffraktogramm verglichen, um aus der größten Ähnlichkeit zwischen experimentellem und simuliertem Streifenmuster die tatsächlich im Experiment vorhandenen Defokussierungs- und Astigmatismuswerte zu bestimmen. Ein Hinweis auf eine maschinelle Mustererkennung findet sich in (A. Thust et al., "Numerical correction of lens aberrations in phase-retrieval HRTEM", Ultramicroscopy 64, 249-264 (1996)) sowie in (S. Uhlemann, M. Haider: "Residual wave aberrations in the first spherical aberration corrected transmission electron microscope", Ultramicroscopy 72, 109-119 (1998)), ohne dass in den zitierten Literaturstellen in irgendeiner Art auf die spezielle algorithmische Implementation der Mustererkennung eingegangen wird. Eine visuelle Mustererkennung per Auge wird in (Johannes Zemlin, Friedrich Zemlin "Diffractogram tableaux by mouse click", Ultramicroscopy 93 77-82,(2002)) beschrieben. Für die praktische, tägliche Anwendung ist letztere visuelle Methode der Mustererkennung aufgrund der langsamen Geschwindigkeit und des subjektiven Charakters des menschlichen Mustervergleichs nicht geeignet, so dass nur der maschinelle Mustervergleich als probates Mittel zur Bestimmung von Defokussierungs- und Astigmatimuswerten bleibt, um Mikroskopaberrationen zu bestimmen.

Der Vergleich eines experimentellen Diffraktogramms mit simulierten Diffraktogrammen ist nach dem Stand der Technik sehr fehleranfällig und ungenau, da das experimentell gemessene Diffraktogramm sowohl von starken additiven als auch von multiplikativen Störungen überlagert ist, deren Stärke die des Nutzsignals bei weitem überragen kann. Die Trennung von starken und schwer quantifizierbaren additiven und multiplikativen Störungen vom eigentlichen Nutzsignal stellt eine Herausforderung dar, die bisher nicht zufrieden stellend gelöst ist. Zum einen besteht die Gefahr, dass das Nutzsignal vor dem Störhintergrund überhaupt nicht erkannt wird, d.h. dass das Störsignal als Nutzsignal aufgefasst wird, was zu einem völlig falschen Ergebnis bzw. einem Zusammenbruch der Streifenerkennung führen kann. Zum anderen besteht die Gefahr, dass selbst bei prinzipiell gelungener Trennung von Stör- und Nutzsignal das Ergebnis der Defokussierungs- und Astigmatismusbestimmung den quantitativen Genauigkeitsanforderungen nicht genügt. Im ersteren Fall ist die Justage der Mikroskopaberrationen nicht möglich, im letzteren Fall kann das Mikroskop zwar grob justiert werden, die aufgrund der ungenauen Messung noch vorhandenen Restaberrationen erlauben es jedoch nicht, die Leistungsfähigkeit des Mikroskops optimal auszuschöpfen.

Aufgabe und Lösung

Aufgabe der Erfindung ist daher, ein Verfahren zur Messung der Ähnlichkeit zweier Bilder zur Verfügung zu stellen, welches gegen Störungen unempfindlicher ist als die Verfahren nach dem Stand der Technik und insbesondere für die Bestimmung von Astigmatismus und Defokussierung in Elektronenmikroskopen verwendet werden kann. Aufgabe der Erfindung ist außerdem, ein Elektronenmikroskop zur Durchführung des Verfahrens zur Verfügung zu stellen.

Diese Aufgaben werden erfindungsgemäß gelöst durch ein Verfahren gemäß Anspruch 1 sowie ein Elektronenmikroskop gemäß Anspruch 12. Weitere vorteilhafte Ausgestaltungen ergeben sich jeweils aus den darauf rückbezogenen Unteransprüchen.

Gegenstand der Erfindung

Im Rahmen der Erfindung wurde ein Verfahren zur Messung der Ähnlichkeit zweier zweidimensionaler, aus Intensitätswerte tragenden Pixeln zusammengesetzter Bilder entwickelt. Dabei ist zumindest ein Bild mit einem Zusatzsignal behaftet, dessen Ortsabhängigkeit oder Symmetrieeigenschaften zumindest schätzungsweise bekannt sind.

Der Begriff des Bildes im Sinne dieser Erfindung ist nicht auf Abbildungen im Ortsraum eingeschränkt, sondern kann insbesondere auch Fourier-Darstellungen im Ortsfrequenzraum und hier speziell von Elektronenmikroskopen gelieferte Diffraktogramme umfassen.

Unter einem Zusatzsignal im Sinne dieser Erfindung wird insbesondere ein additives und/oder multiplikatives Signal verstanden, welches im Bereich des Bildes wesentlich stärker sein kann und sich auch stärker verändern kann als das im Bild vorhandene Nutzsignal, das der Anwender weiterzuverarbeiten wünscht. Ein Zusatzsignal erschwert in der Regel die Ähnlichkeitsmessung und kann auch ihr Ergebnis verfälschen.

Häufig sind die Ortsabhängigkeit oder die Symmetrieeigenschaften des Zusatzsignals zumindest qualitativ bekannt. Bei elektronenmikroskopischen Abbildungen trifft dies insbesondere auf die Streufunktion der Atome im betrachteten Objekt, die durch mit der Objektdicke zusammenhängende kinematische Einhüllende, durch teilweise zeitliche oder räumliche Kohärenz bedingte dämpfende Einhüllende und die Modulationsübertragungsfunktion des für die Bildaufnahme verwendeten Detektors zu. Auch statistisches Bildrauschen kann, abhängig von seiner experimentellen Quelle, ein derartiges Zusatzsignal sein. Rauschen ist grundsätzlich ein statistisches Phänomen; dennoch unterliegt das Rauschverhalten häufig systematischen Gesetzmäßigkeiten. Beispielsweise kann der Zeitmittelwert des Rauschens in vorhersehbarer Weise ortsabhängig sein. Ebenso ist es möglich, dass die Ortsabhängigkeit und/oder die Symmetrieeigenschaften des Zusatzsignals zwar a priori unbekannt, jedoch aus dem mit ihm behafteten Bild klar ersichtlich sind.

Erfindungsgemäß werden die Bilder nun derart in wechselseitig identische Teilbilder partitioniert, dass die Ausdehnung mindestens eines Teilbilds in Richtung des Gradienten des Zusatzsignals kleiner ist als die Ausdehnung dieses Teilbilds in der dazu senkrechten Richtung. Sodann werden wechselseitig zusammengehörende Teilbilder miteinander verglichen, wobei der Vergleich unabhängig vom Kontext des Gesamtbildes erfolgen sollte. Die Ergebnisse dieser Vergleiche werden schließlich zu einem Gesamtmaß für die Ähnlichkeit der beiden Bilder zusammengeführt.

Es wurde erkannt, dass selbst grobe Kenntnisse oder auch nur Annahmen über Ortsabhängigkeit oder Symmetrieeigenschaften des Zusatzsignals in der Regel ausreichen, um zumindest die Richtung seines Gradienten abschätzen zu können. Durch eine geringe Ausdehnung des Teilbilds in Richtung dieses Gradienten variiert nun das Zusatzsignal innerhalb dieses Teilbilds vergleichsweise schwach. Durch eine im Vergleich hierzu große Ausdehnung in der dazu senkrechten Richtung enthält das Teilbild gleichzeitig viele auf das Nutzsignal zurückgehende Strukturen, die für die Messung der Ähnlichkeit herangezogen werden können.

Der Durchgriff des Zusatzsignals auf das Endergebnis der Ähnlichkeitsmessung wird somit vermindert, ohne dass das Zusatzsignal experimentell genauer bestimmt werden muss. Eine derartige Bestimmung war nach dem Stand der Technik regelmäßig erforderlich, was häufig zu einem vollständigen Versagen der Ähnlichkeitsmessung führte.

Es wurde erkannt, dass die erfindungsgemäße Partitionierung insbesondere den Durchgriff von additiven und multiplikativen Zusatzsignalen, welche sich im Gesamtbild räumlich stark verändern, auf das Messergebnis vermindert. Innerhalb der Teilbilder wirken diese Zusatzsignale näherungsweise nur als additive beziehungsweise multiplikative Konstanten, die sich nicht auf den Vergleich auswirken.

Dies sei an einem Beispiel verdeutlicht: Man betrachte ein beliebiges Originalbild mit beliebigen Strukturen und stelle daraus ein gestörtes Bild her, bei dem in einer Bildhälfte sämtliche Intensitätswerte verdoppelt sind. Das gestörte Bild ist also in einer Bildhälfte mit einem multiplikativen Zusatzsignal behaftet. Ein Bildvergleich nach dem Stand der Technik, etwa mit Hilfe der zweidimensionalen Korrelationsfunktion, attestiert daraufhin schon eine deutlich verminderte Ähnlichkeit zwischen Originalbild und gestörtem Bild, obwohl sich an den Strukturen nichts Nennenswertes geändert hat. Wird erfindungsgemäß partitioniert, wobei die beiden Bildhälften als Teilbilder gewählt werden, werden Originalbild und gestörtes Bild als nahezu identisch angesehen. Das erfindungsgemäße Verfahren ist somit besser zum Vergleich der Ähnlichkeit von Strukturen in Bildern geeignet als die Verfahren nach dem Stand der Technik ohne Partitionierung.

Der Begriff des Teilbildes ist ausdrücklich nicht auf rechteckige Bildausschnitte beschränkt. Ein Teilbild kann beispielsweise auch kreis- oder ringförmig sein. Es muss nicht flächig sein, sondern kann beispielsweise auch eine Linienform aufweisen, wobei die Linie mindestens eine Breite von einem Pixel aufweisen sollte.

Generell sollten die Teilbilder die Isolinien beziehungsweise Isoflächen repräsentieren, auf denen sich das Zusatzsignal nur schwach ändert. Zugleich sollte ein Teilbild immer eine charakteristische und eindeutig erkennbare Variation im Nutzsignal enthalten, die für den Vergleich herangezogen werden kann.

Weisen beispielsweise sowohl Nutzsignal als auch Zusatzsignal eine kreisförmige Symmetrie auf, so sind kreisringförmige Teilbilder ungeeignet, da auf ihnen auch das Nutzsignal konstant ist. Im Speziellen Beschreibungsteil ist ein Ausführungsbeispiel für den in diesem Fall notwendigen Kompromiss zwischen der Beeinflussung durch das Zusatzsignal und der Aussagekraft des mit dem Teilbild erfassten Nutzsignals angegeben.

Bei scannenden Bildgebungsverfahren, wie etwa der Rastersondenmikroskopie, werden die Pixel eines Bildes häufig zeitlich nacheinander aufgenommen. Rastert etwa eine Spitze über eine Probe, wird das Bild Zeile für Zeile aufgenommen. Bei derartigen Bildaufnahmeverfahren kommt es häufig zu streifenartigen Artefakten, da der Zeitabstand zwischen in Scanrichtung benachbarten Bildpixeln wesentlich geringer ist als der Zeitabstand zwischen zwei in der dazu senkrechten Richtung benachbarten Bildpixeln. In diesem Fall sind linienförmige, schmale Streifen als Teilbilder vorteilhaft.

Gegebenenfalls kann es sinnvoll sein, die Bilder vor der Partitionierung in eine Darstellung zu transformieren, in der eine sinnvolle Partitionierung in Teilbilder klarer ersichtlich ist. Beispielsweise ist der Übergang zur Fourier-Darstellung sinnvoll, wenn das Zusatzsignal in dieser Darstellung Symmetrien oder auch Isotropien in bestimmten Raumrichtungen aufweist. Bei sehr großen Intensitätsunterschieden innerhalb der Bilder kann es auch sinnvoll sein, sie vor der Partitionierung zu logarithmieren.

Vorteilhaft werden die Bilder in Polarkoordinaten bearbeitet. Sind die Bilder in einem elektronischen Speicher abgelegt, führt die Darstellung in Polarkoordinaten zu einer Anordnung der Daten im Speicher, die bei bestimmten Ausgestaltungen des Ähnlichkeitsvergleichs sequentiell ausgelesen werden kann. Eine gegebene Datenmenge kann sequentiell sehr viel schneller ausgelesen werden als in wahlfreier Reihenfolge.

Die wechselseitig zusammengehörenden Teilbilder werden vorzugsweise mit einem Ähnlichkeitsmaß aus der Gruppe Kreuzkorrelationskoeffizient, Summe der Fehlerquadrate oder Chi-Quadrat-Summe miteinander verglichen. Diese Ähnlichkeitsmaße ändern sich nicht, wenn das eine Teilbild gegenüber dem wechselseitig zusammengehörenden Teilbild um eine additive oder multiplikative Konstante geändert wird.

Sind die Bilder um einen Offset lateral gegeneinander verschoben, so sollte dieser zunächst über das Maximum der Korrelationsfunktion bestimmt werden. Vor dem weiteren Ähnlichkeitsvergleich sollten die Bilder dann um den ermittelten Offset gegeneinander verschoben werden.

Vorzugsweise werden die Ergebnisse der Vergleiche von Teilbildern über eine Linearkombination zu einem Gesamtmaß für die Ähnlichkeit der beiden Bilder zusammengeführt. Beispielsweise können Messergebnisse für die Ähnlichkeit von Teilbildern, die mit einem Ähnlichkeitsmaß gewonnen wurden, aufsummiert werden. Sofern es Gründe dafür gibt, einzelne Teilbilder gegenüber anderen zu bevorzugen, kann diesem in der Linearkombination über unterschiedliche Gewichtungsfaktoren für diese Teilbilder Rechnung getragen werden.

Beispielsweise können die Gewichtungsfaktoren umso höher sein, je mehr Pixel die Teilbilder enthalten. Ein höherer Gewichtsfaktor entspricht dann bei zweidimensionalen Teilbildern einer größeren Fläche und bei linienförmigen, quasi-eindimensionalen Teilbildern einer größeren Linienlänge. Die Anzahl der Pixel ist insofern ein sinnvolles Kriterium für eine unterschiedliche Gewichtung der Teilbilder, als ein Teilbild mit mehr Pixeln in der Regel auch mehr auf das Nutzsignal zurückgehende Features enthält.

Es kann aber auch experimentelle Kriterien für eine Festlegung unterschiedliche Gewichtungsfaktoren für verschiedene Teilbilder geben. So können sich etwa verschiedene Teilbilder hinsichtlich ihres Durchgriffs auf die Messgröße unterscheiden, die aus dem Gesamtergebnis für die Ähnlichkeit ermittelt werden soll. Beispielsweise wirken sich in der Transmissionselektronenmikroskopie Defokussierung und Astigmatismus auf höhere Ortsfrequenzen wesentlich stärker aus als auf niedrigere; sie hängen im Wesentlichen quadratisch vom Betrag der Ortsfrequenz ab. Soll die erfindungsgemäß bestimmte Ähnlichkeit zweier Bilder als Maß für Defokussierung oder Astigmatismus eines der Bilder dienen, kann es daher sinnvoll sein, zu höheren Ortsfrequenzen gehörende Teilbilder stärker zu gewichten. Dies ist in einer Fourier-Darstellung besonders einfach möglich, da der radiale Abstand vom Mittelpunkt der Darstellung den Betrag der Ortsfrequenz angibt.

Es gibt andererseits Situationen, in denen gerade Bereiche hoher Ortsfrequenzen niedriger gewichtet werden sollten. In der Transmissionselektronenmikroskopie kann auf Grund von Kohärenzeffekten das Nutzsignal bei hohen Ortsfrequenzen wesentlich stärker gedämpft sein als bei niedrigen Ortsfrequenzen, so dass sich das Verhältnis zwischen dem Nutzsignal und dem Zusatzsignal bei hohen Ortsfrequenzen verschlechtert.

Andere Einflussgrößen, die in die Gewichtungsfaktoren eingehen könnten, sind beispielsweise in der Transmissionselektronenmikroskopie die Ortsauflösung des Detektors oder eine ortsfrequenzabhängige Streustärke des untersuchten Objekts.

In einer besonders vorteilhaften Ausgestaltung der Erfindung hängt das Zusatzsignal in Polarkoordinaten stärker vom Radius ab als vom Azimut. Hierunter ist zu verstehen, dass für mindestens die überwiegende Anzahl der Pixel der radiale Gradient des Zusatzsignals größer ist als sein azimutaler Gradient. Als Teilbilder sind in diesem Fall insbesondere kreisringfömige Bereiche geeignet. Die Form eines oder mehrerer Teilbilder kann aber auch beispielsweise um eine Kreisringlinie herum periodisch moduliert sein, um sicherzustellen, dass jedes Teilbild klare auf das Nutzsignal zurückgehende Strukturen enthält.

Bei der Bildaufnahme mit einem Transmissionselektronenmikroskop können stets Bedingungen hergestellt werden, unter denen in der Fourier-Darstellung und hier insbesondere bei Diffraktogrammen das Zusatzsignal in Polarkoordinaten im Wesentlichen nur vom Radius abhängt, azimutal jedoch isotrop ist. Hierfür genügt es, sowohl eine Drift des Objekts als auch unüblich hohe Aberrationen zu unterbinden. Beide Bedingungen sind experimentell überprüfbar. Unüblich hohe Aberrationen können gegebenenfalls auch iterativ behoben werden.

Das Zusatzsignal hat bei der Bildaufnahme mit einem Transmissionselektronenmikroskop sowohl einen additiven als auch einen multiplikativen Anteil.

Der additive Anteil wird durch inelastisch gestreute Elektronen bewirkt. Da das Objekt amorph ist und die inelastischen Atomstreufaktoren isotrop sind, ist dieser additive Anteil insgesamt isotrop. Jedoch hängt er sehr stark vom Betrag der Ortsfrequenz ab. In einer Fourier-Darstellung, in der Diffraktogramme üblicherweise angegeben werden, hängt dieser additive Anteil daher stark vom Radius ab, ist jedoch azimutal isotrop.

Der multiplikative Anteil setzt sich aus Beiträgen durch die Einhüllenden der partiellen zeitlichen und räumlichen Kohärenz, die Atomstreufaktoren und durch die Modulationsübertragungsfunktion des für die Bildaufnahme verwendeten Detektors zusammen. Alle diese Beiträge sind bei guter Justage des Elektronenmikroskops in der Fourier-Darstellung ebenfalls azimutal isotrop, hängen also nur vom Betrag der Ortsfrequenz ab. Diese Abhängigkeit ist jedoch sehr stark und auch sehr kompliziert. Durch die erfindungsgemäße Partitionierung wird unterbunden, dass sie auf das Ergebnis der Ähnlichkeitsmessung durchschlägt.

Die Teilbilder müssen nicht voneinander beabstandet sein, sondern dürfen sich im Gegenteil sogar überlappen. Somit kann die Vereinigungsmenge aller Teilbilder einen Anteil von mindestens 80 Prozent, insbesondere von mindestens 90 Prozent aller zur Verfügung stehenden Pixel umfassen. Idealerweise umfasst die Vereinigungsmenge aller Teilbilder alle Pixel mit Ausnahme physikalisch nicht sinnvoller Bereiche, wie sie beispielsweise im Zentrum von mit Elektronenmikroskopen aufgenommenen Diffraktogrammen vorkommen. Die in den Bildern enthaltene Information wird dann in einer ersten Stufe nur jeweils in kleinen unabhängigen Portionen ausgewertet, insgesamt jedoch vollständig genutzt.

In einer besonders vorteilhaften Ausgestaltung der Erfindung werden ein experimentell gemessenes Bild und ein simuliertes Bild als Bilder gewählt. Das Verfahren kann dann verwendet werden, um die Werte von Messgrößen, die sich als Simulationsparameter für die Generierung des simulierten Bildes verwenden lassen, für das experimentell gemessene Bild näherungsweise zu bestimmen. Hierfür sollten Teilbilder gewählt werden, auf denen die Intensitätswerte des simulierten Bildes mindestens über eine vorgegebene Schwankungsbreite variieren, damit sich die Störungen im experimentell gemessenen Bild nicht zu großen Fehlern in den bestimmten Messgrößen verstärken.

Messgrößen können mit dem erfindungsgemäßen Verfahren beispielsweise bestimmt werden, indem aus dem Messergebnis des Verfahrens ein neues simuliertes Bild ermittelt wird, welches zum experimentell gemessenen Bild ähnlicher ist als das ursprüngliche simulierte Bild. Hierfür können Parameteroptimierungsverfahren verwendet werden. Als Optimierungsverfahren eignet sich beispielsweise ein Simplexverfahren oder auch ein gradientenfreies Optimierungsverfahren, wie etwa das Hooke-Jeeves-Verfahren. Es kann iterativ so lange optimiert werden, bis maximale Ähnlichkeit zwischen dem experimentell gemessenen und dem simulierten Bild erzielt ist. Die Simulationsparameter, mit denen dieses Ergebnis erreicht wird, können dann näherungsweise als Werte für die zugehörigen Messgrößen am experimentell gemessenen Bild angesehen werden.

Beispielsweise kann ein Elektronenmikroskop für die Gewinnung des experimentell gemessenen Bildes verwendet werden. Dann lässt sich das Verfahren beispielsweise nutzen, um auf dem Umweg über die Ähnlichkeit zwischen simuliertem und experimentell gemessenem Bild die nicht direkt messbaren Größen Astigmatismus und Defokussierung zu bestimmen. Hierfür werden mindestens Astigmatismus und Defokussierung als Simulationsparameter für die Generierung des simulierten Bildes herangezogen.

Aus den Astigmatismen und Defokussierungen einer Reihe von experimentell gemessenen Bildern können vorteilhaft, beispielsweise gemäß der Zemlin-Methode, Aberrationen des Elektronenmikroskops bestimmt werden. Dies ist grundsätzlich möglich, da es sich bei Astigmatismus und Defokussierung ebenfalls um Aberrationen im weiteren Sinne handelt. Somit sind diese Größen physikalisch mit den zu bestimmenden Aberrationen verknüpft. Die zu bestimmenden Aberrationen sind die Lösungen eines überbestimmten linearen Gleichungssystems, dessen Koeffizienten aus allen gemessenen Astigmatismen und Defokussierungen bestimmt werden.

Diese Prozedur ist mit der Aufgabe vergleichbar, ein unbekanntes Objekt in einem geschlossenen Behälter zu identifizieren, der nur über eine kleine Öffnung eingesehen werden kann. Der Reihe von gemessenen Bildern entspricht ein mehrfaches Schütteln des Behälters, um eine andere Ansicht des Objekts zu erhalten. Je mehr Ansichten zur Verfügung stehen, desto präziser kann das Objekt identifiziert werden. Kleine Störungen und Fehler in den Ansichten allerdings können zu einem völlig abwegigen Ergebnis der Identifizierung führen. Dieses Analogon verdeutlicht, wie wichtig es ist, durch das erfindungsgemäße Verfahren den Bildvergleich unempfindlicher gegen Störungen zu machen.

Insbesondere kann das Elektronenmikroskop auf eine Korrektur der bestimmten Aberrationen eingestellt und das Verfahren anschließend neu gestartet werden. Auf diese Weise lassen sich die Korrektur der Aberrationen und damit die Auflösung des Mikroskops iterativ optimieren.

Das Verfahren kann nicht nur zur einmaligen Justage des Mikroskops vor der eigentlichen Messung verwendet werden, sondern auch zur Nachjustage während des Messbetriebs. Dies ist für höchste Auflösungen auch erforderlich, da einige Störeinflüsse, die sich auf die Aberrationen auswirken, von Umgebungsbedingungen wie etwa der Temperatur abhängen.

In einer besonders vorteilhaften Ausgestaltung der Erfindung wird das simulierte Bild vor der Partitionierung durch einen Schnellvergleich mit dem experimentell gemessenen Bild ausgewählt. Es wurde erkannt, dass insbesondere bei der Bestimmung von Messgrößen durch das erfindungsgemäße Verfahren zunächst sehr viele Bilder als simulierte Bilder in Frage kommen. Beispielsweise kann ein Katalog von simulierten Bildern vorliegen, die mit verschiedenen Werten für die zu bestimmenden Messgrößen simuliert wurden. Welches der Bilder aus diesem Katalog dem experimentell gemessenen Bild am ähnlichsten ist, tritt durch den Schnellvergleich deutlich zu Tage. Anschließend können einige wenige Abwandlungen dieses Bildes bestimmt und über die Partitionierung mit dem experimentell gemessenen Bild verglichen werden, um die Messgrößen genauer zu bestimmen. Die Partitionierung wird dann nur für diese wenigen Abwandlungen durchgeführt und nicht für alle Bilder aus dem ursprünglichen Katalog. Da die Partitionierung wesentlich länger dauert als ein Schnellvergleich, führt dies zu einer drastischen Verringerung der insgesamt benötigten Rechenzeit.

In einem Ausführungsbeispiel des erfindungsgemäßen Verfahrens umfasst der Katalog 40.000 simulierte Bilder. Der Schnellvergleich bewältigt 200.000 Ähnlichkeitsvergleiche pro Sekunde, findet also in 0,2 Sekunden das simulierte Bild aus dem Katalog, welches dem experimentell gemessenen Bild am ähnlichsten ist. Würden alle Bildvergleiche über die Partitionierung durchgeführt, wobei für einen Vergleich 1,5 Millisekunden benötigt werden, würde der Vergleich des experimentell gemessenen Bildes mit allen 40.000 simulierten Bildern aus dem Katalog etwa eine Minute in Anspruch nehmen.

Für den Schnellvergleich ist es vorteilhaft, die Intensitätswerte der Pixel mindestens eines der Bilder auf 16 oder weniger, insbesondere auf zwei, mögliche Werte pro Pixel zu diskretisieren. Der Schnellvergleich kommt dann mit weniger Rechenoperationen aus. Als Methode für den Schnellvergleich eignet sich vorteilhaft eine logische Verknüpfung und hier insbesondere das ausschließliche Oder (XOR), wobei für die XOR-Verknüpfung eine Diskretisierung auf zwei mögliche Werte pro Pixel notwendig ist. Es sind auch Abwandlungen der XOR-Verknüpfung, beispielsweise die XNOR-Verknüpfung, geeignet. Die Wahrheitstabelle der logischen Verknüpfung sollte so beschaffen sein, dass ihr Ausgabewert eindeutig aussagt, ob die Eingabewerte identisch sind oder nicht.

In einem Ausführungsbeispiel werden für den Schnellvergleich mit der XOR-Verknüpfung im experimentell bestimmten Bild und im simulierten Bild jeweils acht benachbarte Pixel durch die acht Bits eines Bytes repräsentiert. Sind in den beiden Bildern zwei Pixelwerte gleich, ergibt die XOR-Verknüpfung im resultierenden Bit eine 0; sind sie verschieden, ist das resultierende Bit eine 1. Damit liefert der Ausgabewert 0 oder 1 eine eindeutige Aussage darüber, ob die eingegebenen Pixelwerte (Bits) identisch sind. Insgesamt entsteht aus der XOR-Verknüpfung der zu beiden Bildern gehörenden Bytes ein resultierendes Byte, in dem die Anzahl der Einsen die Anzahl der übereinstimmenden Pixel (von 0 bis 8) angibt. Die Umrechnung des Bytewerts in diese Anzahl (Vergleichszahl) erfolgt über eine Lookup-Table (Wertetabelle) mit 256 Einträgen. Am Ende werden alle (hier: 512) Vergleichszahlen addiert. Da ein Byte nur einen kleinen Bereich im Diffraktogramm repräsentiert, ist dieses Verfahren resistent gegen langreichweitige Variationen des Zusatzsignals.

Auch bei dem Schnellvergleich handelt es sich bereits um ein Ausführungsbeispiel eines Verfahrens zur Messung der Ähnlichkeit zweier zweidimensionaler, aus Intensitätswerte tragenden Pixeln zusammengesetzter Bilder. Die Bilder werden in wechselseitig identische Teilbilder partitioniert, die in diesem Ausführungsbeispiel durch Bytes repräsentiert werden. Wechselseitig zusammengehörende Teilbilder (Bytes) werden miteinander verglichen, hier durch die XOR-Verknüpfung. Die Ergebnisse dieser Vergleiche, in diesem Ausführungsbeispiel die Vergleichszahlen, werden zu einem Gesamtmaß für die Ähnlichkeit der beiden Bilder zusammengeführt, in diesem Ausführungsbeispiel durch Addition aller Vergleichszahlen. Durch seine Resistenz gegen langreichweitige Variationen des Zusatzsignals wirkt dieses vereinfachte Verfahren analog zu dem Verfahren gemäß Hauptanspruch, bei dem die Ausdehnung mindestens eines Teilbilds in Richtung des Gradienten des Zusatzsignals kleiner ist als die Ausdehnung dieses Teilbilds in der dazu senkrechten Richtung. Insbesondere können analog zum Verfahren gemäß Hauptanspruch auch Messgrößen, wie etwa Defokussierung und Astigmatismus eines Elektronenmikroskops, bestimmt werden. Das vereinfachte Verfahren kann jedoch auch völlig losgelöst von diesem eingesetzt werden. Wie weiter unten ausgeführt, lassen sich auch mit der simplen Partitionierung in Bytes, in denen nebeneinander liegende Pixel zusammengefasst sind, Defokussierung und Astigmatismus von Elektronenmikroskopen um einen Faktor 2 genauer bestimmen als nach dem Stand der Technik.

Vorteilhaft wird das simulierte Bild aus einem vorberechneten Katalog ausgewählt. Dies ist bei der Bestimmung von Defokussierung und Astigmatismus möglich, da die Menge der möglichen auftretenden Werte durch die Hardware des Mikroskops vorgegeben und daher bei jeder Messung gleich ist. In diesem Fall ist es sinnvoll, das experimentell gemessene Bild auf eine geringere Auflösung herunterzurechnen. Weisen die Bilder Symmetrien auf, wie es bei Diffraktogrammen der Fall ist, sollte für den Schnellvergleich dann zusätzlich nur der nicht redundante Teil der Bilder (bei Diffraktogrammen nach Mittelung einer der vier Quadranten) herangezogen werden. Durch diese Maßnahmenkombination wird der Speicherbedarf des Katalogs begrenzt, ohne allzu große Abstriche bei der Genauigkeit des Schnellvergleichs machen zu müssen.

Im Rahmen der Erfindung wurde ein Elektronenmikroskop mit verbesserter interpretierbarer Auflösung entwickelt.

Unter der interpretierbaren Auflösung wird das Inverse der niedrigsten Ortsfrequenz verstanden, bei der eine Unsicherheit bei der Bestimmung der zugehörigen Aberrationsfunktionen auftritt, die größer als $\pi/4$ (Rayleigh-Kriterium) ist. Bei noch höheren Ortsfrequenzen ist von einer Unsicherheit in der Aberrationsfunktion von mehr als $\pi/4$ auszugehen. Die zugehörige Information wird im Bild nicht mehr korrekt dargestellt und kann somit nicht mehr ad-hoc durch Betrachtung interpretiert werden.

Dieses Mikroskop umfasst einen digitalen Bildsensor, eine Vorrichtung zur Verkippung des Elektronenstrahls gegenüber dem zu untersuchenden Objekt, eine Linsenanordnung zur Korrektur von Aberrationen sowie einer Steuereinheit für diese Linsenanordnung.

Erfindungsgemäß ist nun eine Justiervorrichtung für die Linsenanordnung vorgesehen. Diese Justiervorrichtung umfasst

- eine Simulationseinheit, die ideale elektronenmikroskopische Bilder von Teststrukturen mit vorgegebenen Werten für deren Defokussierung und Astigmatismus zu liefern vermag;
- eine mit dem Bildsensor und der Simulationseinheit verbundene Vergleichseinheit, die die Ähnlichkeit zwischen einem vom Bildsensor und einem von der Simulationseinheit gelieferten Bild zu messen vermag; und
- eine mit der Vergleichseinheit und der Steuereinheit verbundene Auswerteeinheit, die aus der gemessenen Ähnlichkeit sowie den dazugehörigen Werten für Defokussierung und Astigmatismus die Aberrationen des Elektronenmikroskops näherungsweise zu bestimmen und diese in einen Stellbefehl für die Steuereinheit umzusetzen vermag.

Der Begriff des Bildes ist auch hier nicht auf direkte Abbildungen im Ortsraum eingeschränkt, sondern umfasst auch beispielsweise Fourier-Darstellungen im Fourier-Raum und hier insbesondere Diffraktogramme oder auch Logarithmen dieser Diffrah-togramme.

Der Begriff des Bildes ist auch nicht auf Darstellungen in kartesischen Koordinaten eingeschränke, sondern umfasst insbesondere auch Darstellungen in Polarkoordinaten. Beispielsweise werden Diffraktogramme auf Grund ihrer Symmetrieeigenschaften häufig in Polarkoordinaten dargestellt.

Nach der Abbildung einer Teststruktur mit dem Mikroskop können mit der Simulationseinheit so lange ideale Bilder derselben Teststruktur erzeugt werden, bis die Vergleichseinheit eine hohe Ähnlichkeit zwischen dem idealen und dem mit dem Mikroskop bestimmten Bild feststellt.

Die gemessene Ähnlichkeit kann dann zusammen mit den dazugehörigen Werten für die Defokussierung und den Astigmatismus verwendet werden, um die Aberrationen des Elektronenmikroskops zu bestimmen. Der Stellbefehl für die Steuereinheit wiederum ist so geartet, dass die bestimmten Aberrationen bei der nächsten Bildaufnahme aufgehoben werden.

Die Aberrationen des Mikroskops hängen von einigen im Laufe der Zeit veränderlichen Randbedingungen ab. Beispiele für derartige Randbedingungen sind die Raumtemperatur, die Kühlwassertemperatur sowie zeit- und ortsabhängige elektrostatische Felder auf Grund von Aufladungen des Objekts. Die erfindungsgemäße Justiereinheit ist in der Lage, während des Messbetriebs die Korrektur der Aberrationen an diese veränderten Randbedingungen anzupassen.

In einer besonders vorteilhaften Ausgestaltung der Erfindung vermag die Vergleichseinheit das erfindungsgemäße Verfahren zur Messung der Ähnlichkeit zweier Bilder durchzuführen. Hierzu ist sie beispielsweise dann in der Lage, wenn sie Mittel für eine derartige Partitionierung des idealen und des mit dem Mikroskop bestimmten (vom digitalen Bildsensor gelieferten) Bildes in wechselseitig identische Teilbilder aufweist, dass die Ausdehnung mindestens eines Teilbilds in Richtung des Gradienten eines in mindestens einem der Bilder vorhandenen Zusatzsignals kleiner ist als die Ausdehnung dieses Teilbilds in der dazu senkrechten Richtung. Analog zur Beschreibung des Verfahrens wird unter einem Zusatzsignal insbesondere ein additives und/oder multiplikatives Signal verstanden, welches im Bereich des Bildes wesentlich stärker ist und sich auch stärker verändert als das im Bild vorhandene Nutzsignal, das der Anwender weiterzuverarbeiten wünscht. Ein Zusatzsignal erschwert in der Regel die Ähnlichkeitsmessung und kann auch ihr Ergebnis verfälschen.

Das erfindungsgemäße Verfahren ist sowohl schneller als auch genauer als die Verfahren nach dem Stand der Technik, deren Messergebnisse insbesondere durch Störungen in den mit dem Mikroskop aufgenommenen Bildern stark verfälscht werden. Ist die Vergleichseinheit zur Durchführung des erfindungsgemäßen Verfahrens in der Lage, können die Aberrationen des Mikroskops von der Auswerteeinheit genauer bestimmt werden. Der von der Auswerteeinheit generierte Stellbefehl für die Steuereinheit bewirkt dann, dass die Linsenanordnung die vorliegenden Aberrationen des Mikroskops fast vollständig kompensiert, aber auch nicht überkompensiert. Im Ergebnis steigt die mit dem Mikroskop erzielbare interpretierbare Auflösung.

In einer weiteren vorteilhaften Ausgestaltung der Erfindung umfasst die Vergleichseinheit Mittel für eine Diskretisierung der Intensitätswerte der Pixel mindestens eines Bildes auf 16 oder weniger, insbesondere auf zwei, mögliche Werte pro Pixel. Der Bildvergleich ist dann auf Grund der geringeren zu verarbeitenden Informationsmenge deutlich schneller durchführbar. Für einen solchen schnellen Bildvergleich kann die Vergleichseinheit beispielsweise Mittel für eine ausschließliche Oder-Verknüpfung (XOR) zwischen zwei diskretisierten Bildern umfassen. Sie kann aber auch einen digitalen Signalprozessor (DSP) umfassen. Dieser kann neben der ausschließlichen Oder-Verknüpfung weitere schnelle Vergleichsmethoden ausführen. Die Wahrheitstabelle einer logischen Verknüpfung, die als Vergleichsmethode dient, sollte so beschaffen sein, dass ihr Ausgabewert eindeutig aussagt, ob die Eingabewerte identisch sind oder nicht. Der schnelle Vergleich diskretisierter Bilder wird in dem realisierten Ausführungsbeispiel des Elektronenmikroskops als Vorstufe für den genaueren, aber langsameren Bildvergleich über die Partitionierung eingesetzt. Damit wird die Zeit, die die Justiereinheit zum Ermitteln des passenden Stellbefehls für die Steuereinheit benötigt, drastisch verkürzt.

Die Justiereinheit kann mindestens einen Computer mit einem Computerprogramm umfassen und insbesondere vollständig als Computerprogramm realisiert sein, welches über geeignete Hardwareschnittstellen des Computers mit dem Bildsensor, der Steuereinheit und gegebenenfalls auch der Vorrichtung für die Verkippung des Elektronenstrahls kommuniziert. Der Computer wird dann, analog zu programmierbaren Logikbausteinen, als Universalelektronik eingesetzt, deren Funktion ihr durch das Computerprogramm aufgeprägt wird. Ein Computer als Universalelektronik ist ein Massenprodukt und kostet daher pro Einheit Leistung deutlich weniger als speziell gefertigte Elektronik. Er bietet zudem den Vorteil, dass gewisse spätere Verbesserungen der körperlichen Justiereinheit sich in der unkörperlichen Form des Software-Downloads auf das Elektronenmikroskop übertragen lassen. Eine solche Aktualisierung ist preisgünstig, da keine elektronischen Bauteile als Abfall anfallen und auch der Besuch eines Monteurs entbehrlich ist.

Ist der Computer auch mit der Vorrichtung für die Verkippung des Elektronenstrahls verbunden, kann die Justiereinheit auch die zur Bestimmung von Defokussierung und Astigmatismus erforderlichen Testbilder selbsttätig aufnehmen. Sie kann das Elektronenmikroskop dann ohne jede Interaktion mit dem Benutzer justieren. Beispielsweise kann in Arbeitspausen in bestimmten Zeitabständen eine automatische Nachjustage erfolgen, damit dem nächsten Benutzer ohne Wartezeit sofort die volle interpretierbare Auflösung zur Verfügung steht.

Bei dem Computer kann es sich insbesondere um einen handelsüblichen Arbeitsplatzcomputer mit geeigneten Hardwareschnittstellen, um einen Industrie-PC oder insbesondere auch um den Computer eines Embedded-Systems handeln. Ein Embedded-System enthält bevorzugt nur diejenige Funktionalität, die für seinen Einsatz als Universalelektronik erforderlich ist. Alle übrigen Baugruppen fehlen. Dadurch benötigt ein Embedded-System im Vergleich zu einem Arbeitsplatzcomputer weniger Einbauraum und Energie.

Ausführungsbeispiele des erfindungsgemäßen Verfahrens und des erfindungsgemäßen Elektronenmikroskops vermögen die Defokussierung und den Astigmatismus eines Diffraktogramms mit einer durchschnittlichen Genauigkeit von jeweils etwa 0,2 Nanometern zu messen. Damit ist es möglich, die interpretierbare Auflösung in den Bereich der physikalischen Auflösung von derzeit etwa 0,8 Nanometer zu bringen. Allein der Schnellvergleich mittels der XOR-Verknüpfung erreicht bereits eine Genauigkeit von etwa 2 Nanometer.

Die physikalische Auflösung, die auch Informationslimit genannt wird, ist die Größe des kleinsten, vom Mikroskop noch in irgendeiner Art übertragbaren Objektdetails. Sie bleibt bei einer Änderung von Defokussierung oder Astigmatismus gleich.

Es erscheint in Reichweite (wenn möglich, kurz ausführen), die Aberrationsfunktion auch bei der heute noch nicht realisierbaren physikalischen Auflösung von 0,5 nm noch auf eine bessere Genauigkeit als π/4 zu bestimmen.

Nach dem Stand der Technik konnten Defokussierung und Astigmatismus lediglich bis auf 4 Nanometer genau bestimmt werden, also um einen Faktor 2 schlechter als mit dem erfindungsgemäßen groben Schnellvergleich und um einen Faktor 20 schlechter als über die rechenintensivere Partitionierung.

Spezieller Beschreibungsteil

Nachfolgend wird der Gegenstand der Erfindung anhand von Figuren näher erläutert, ohne dass der Gegenstand der Erfindung dadurch beschränkt wird. Es ist gezeigt:

Figur 1: Experimentell gemessenes (obere linke Hälfte) und simuliertes (untere rechte Hälfte) Diffraktogramm eines dünnen amorphen Objekts.

Figur 2: Vergleich von Nutzsignal (Figur 2a), seiner Überlagerung mit einem multiplikativen Zusatzsignal (Figur 2b) und einer zusätzlichen Überlagerung mit additivem Rauschen als weiteres Zusatzsignal (Figur 2c).

Figur 3: Beispiele für Teilbilder, abhängig vom simulierten Bild.

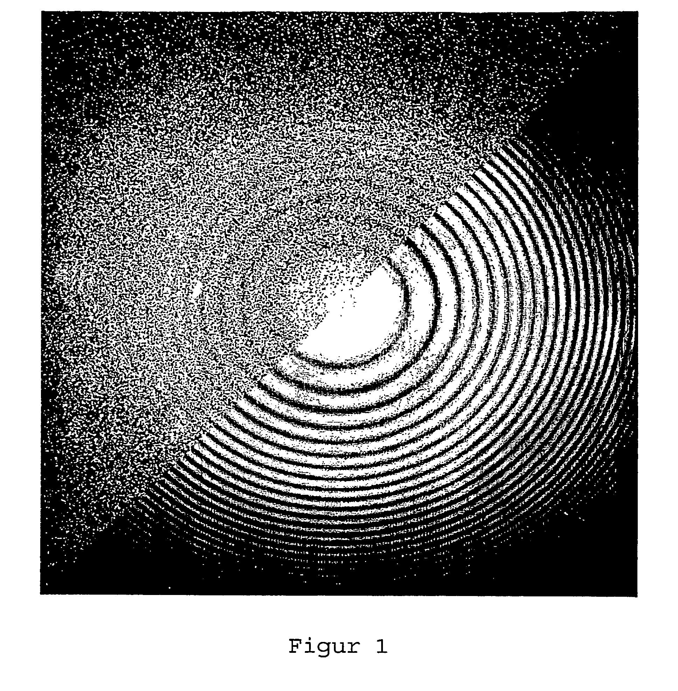

Figur 1 zeigt eine elektronenmikroskopische Abbildung (Diffraktogramm) eines dünnen amorphen Objekts, dargestellt im Fourier-Raum (Ortsfrequenzraum). Die obere linke Hälfte zeigt ein experimentell gemessenes Bild. Die untere rechte Hälfte zeigt das simulierte Bild, das dem experimentell gemessenen Bild am nächsten kommt. Dieses simulierte Bild verkörpert das Nutzsignal, das im experimentell gemessenen Bild enthalten ist. Es enthält jedoch bereits Zusatzsignale wie Dämpfungsenvelopen, die im experimentell gemessenen Bild zwangsläufig auftreten. Dadurch wird sichergestellt, dass die rein visuelle Ähnlichkeit zwischen dem experimentell gemessenen und dem simulierten Bild nur durch Änderungen der beiden interessierenden Messgrößen Defokussierung und Astigmatismus beeinflusst wird.

Die Ringmuster werden auch als Thon-Ringe bezeichnet. Ihre Form hängt vom Einfallswinkel des Elektronenstrahls, der Elektronenwellenlänge, der sphärischen Aberrationskonstante, der effektiven Defokussierung und dem effektiven zweidimensionalen Astigmatismus ab. Deutlich ist im experimentell gemessenen Bild das Rauschen zu erkennen, das die Messung der Ähnlichkeit zwischen experimentell gemessenem und simuliertem Bild erschwert.

Die Thon-Ringe können als das Betragsquadrat der kohärenten Übertragungsfunktion CTF$(g_x,g_y)$ beschrieben werden, welche von zweidimensionalen Koordinaten $(g_x,g_y)$ im Fourier-Raum abhängt. Sie ist gegeben durch

$$\text{CTF}(g_x,g_y) = \sin\left[2\pi\chi(g_x,g_y)\right]$$

worin χ die Aberrationsfunktion ist. Diese ist gegeben durch

$$\chi(g_x,g_y) = \frac{1}{4}C_s\,\lambda^3\,(g_x^2+g_y^2)^2 + \frac{1}{2}Z\,\lambda\,(g_x^2+g_y^2) + \frac{1}{2}A_{2x}\,\lambda\,(g_x^2-g_y^2) + \frac{1}{2}A_{2y}\,\lambda\,(2g_xg_y)$$

und hängt von folgenden Variablen ab:

$C_s$ : sphärische Aberrationskonstante
$\lambda$ : Elektronenwellenlänge
$Z$ : Defokussierung
$A_{2x}$ : x-Komponente des zweidimensionalen Astigmatismusvektors $A_2$
$A_{2y}$ : y-Komponente des zweidimensionalen Astigmatismusvektors $A_2$
$g_x$ : x-Komponente des Beugungsvektors g
gy : y-Komponente des Beugungsvektors g

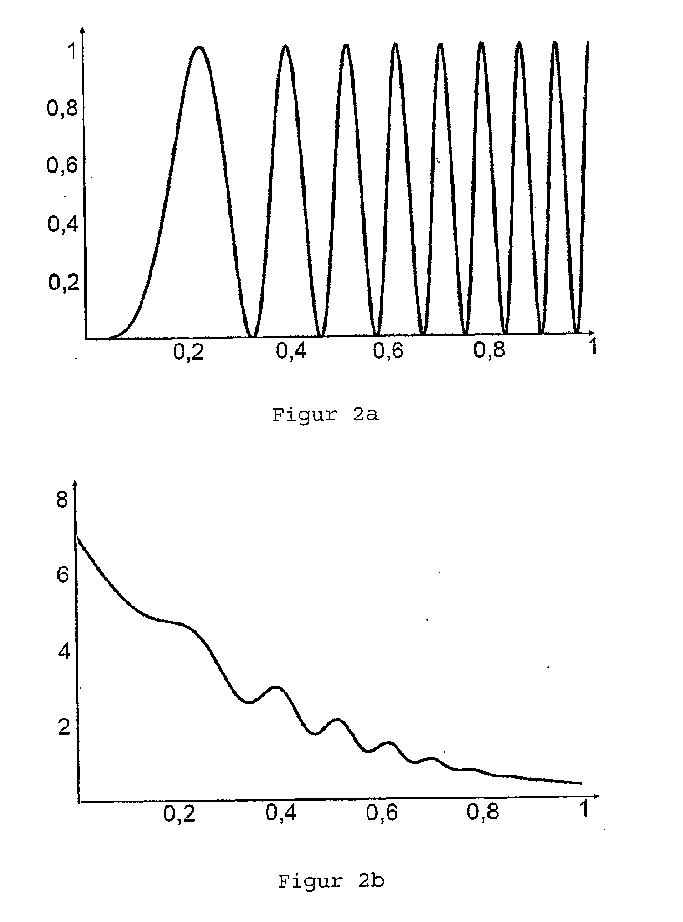

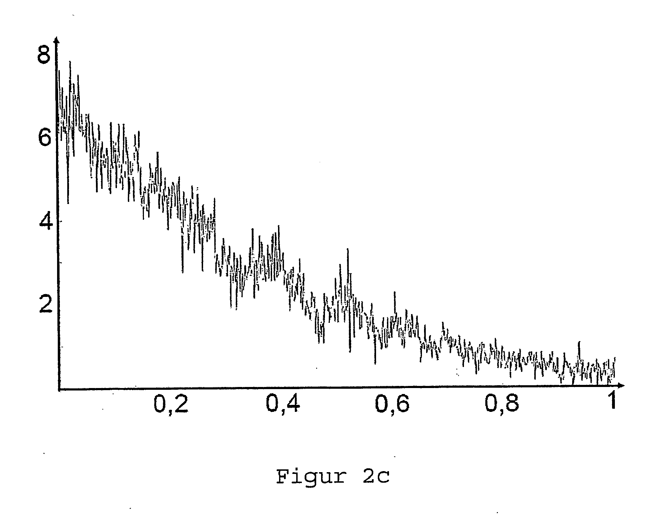

Figur 2 zeigt einen eindimensionalen radialen Schnitt durch ein Diffraktogramm wie aus Figur 1, ausgehend von der Bildmitte. Auf der Ordinatenachse ist die Ortsfrequenz in willkürlichen Einheiten dargestellt. Auf der Abszissenachse ist die Intensität in willkürlichen Einheiten dargestellt. In Figur 2a ist das im Idealfall zu erwartende Nutzsignal dargestellt. Das Signal S($g_x$,$g_y$), von dem hier der Schnitt dargestellt ist, kann beschrieben werden durch

$$S(g_x, g_y) = \left[ \mathrm{CTF}(g_x, g_y) \right]^2$$

Figur 2b zeigt einen Schnitt durch die Überlagerung dieses Nutzsignals mit typischen multiplikativen Zusatzsignalen D($g_x$,$g_y$), wie beispielsweise

- dem Streuquerschnitt der Atome im Objekt;
- dem Einfluss der endlichen Dicke des Objekts;
- dem Einfluss zeitlicher und räumlicher Dekohärenz, durch die ein Teil der Elektronen nicht mehr zum Interferenzmuster beitragen kann;
- der Übertragungsfunktion des Detektors.

Figur 2c zeigt einen Schnitt durch das multiplikativ gestörte Signal, welches zusätzlich noch von additivem Untergrund B($g_x$,$g_y$), der sich im Ortsfrequenzraum langsam ändert, und von statistischem, hochfrequentem Rauschen N($g_x$,$g_y$) (mit einem Signal-Rausch-Verhältnis von ungefähr 1) als weiteres Zusatzsignal überlagert ist. Das Signal E($g_x$, $g_y$), dessen Schnitt hier dargestellt ist, entspricht dem experimentell gemessenen Signal und hat die Form

$$E(g_x, g_y) = S(g_x, g_y) \times D(g_x, g_y) + B(g_x, g_y) + N(g_x, g_y)$$

Offensichtlich hat der in Figur 2c gezeigte Schnitt nur noch sehr wenig mit dem Schnitt aus Figur 2a gemeinsam. Die Zusatzsignale sind um ein Vielfaches stärker als das Nutzsignal. Entsprechend schwierig ist beim zweidimensionalen Bildvergleich die präzise Messung der Ähnlichkeit eines simulierten Bildes mit bestimmten Werten für Defokussierung und Astigmatismus zu einem experimentell gemessenen Bild.

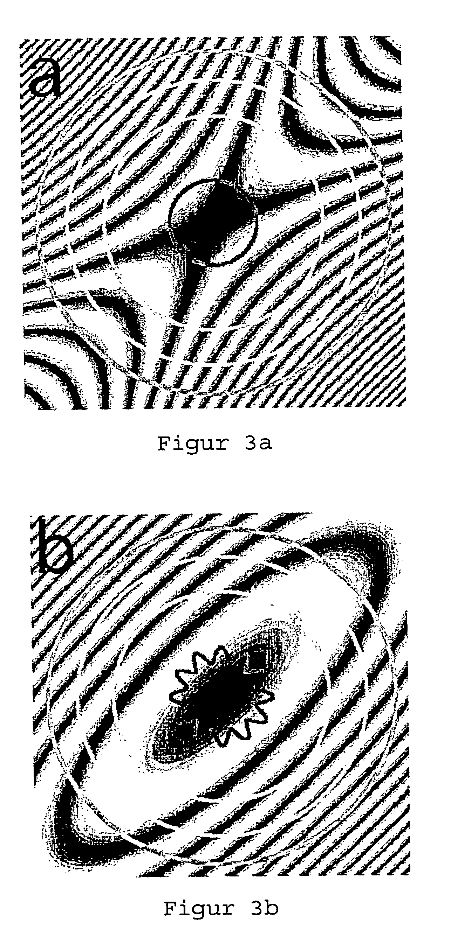

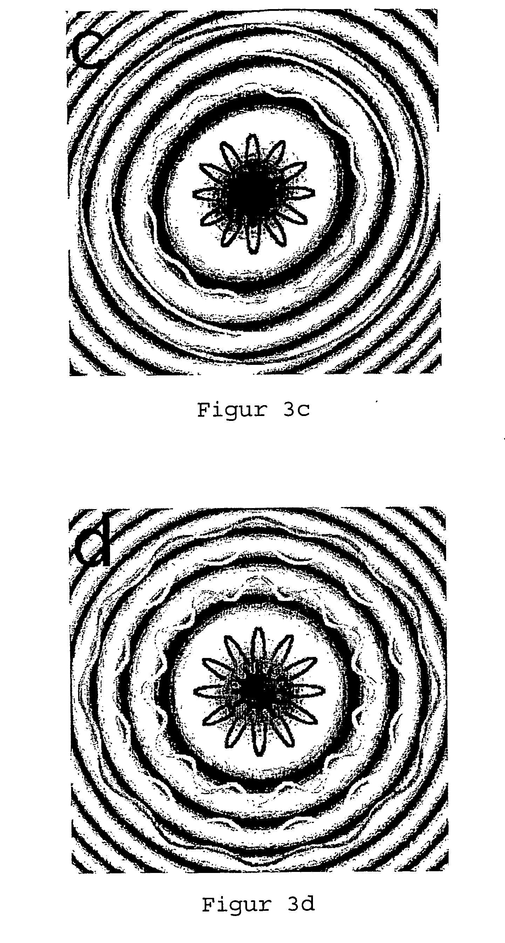

In Figur 3 sind Beispiele für mögliche und sinnvolle Teilbilder aufgezeigt. In Figur 3a (hoher Astigmatismus) wurden Kreisringe gewählt. Der Grund hierfür ist, dass sowohl die multiplikativen als auch die additiven Zusatzsignale im Ortsfrequenzraum (der in allen Figuren für die Darstellung verwendet wird) nur vom Betrag g der Ortsfrequenz abhängen, jedoch kaum von ihrer azimutalen Richtung. Unter Berücksichtigung dieses Charakters der Zusatzsignale hat das experimentell gemessene Signal E($g_x$,$g_y$) die Form

$$E(g_x, g_y) = S(g_x, g_y) \times D(g) + B(g) + N(g)$$

In Polarkoordinaten bedeutet dies, dass die Zusatzsignale nur vom Radius $g = (g_x^2 + g_y^2)^{1/2}$ abhängen, nicht jedoch vom Azimut $\arctan(g_y/g_x)$. Der Gradient der Zusatzsignale ist somit ein rein radialer Gradient. Die Teilbilder sind schmal in Richtung dieses Gradienten, jedoch ausgedehnt in der dazu senkrechten azimutalen Richtung.

Mit Ausnahme des innersten Teilbilds enthält jeder dieser ringförmigen Teilbilder ein Minimum und ein Maximum eines Thon-Rings. Die Intensitätswerte in den linienförmigen Teilbildern variieren über den maximal möglichen Bereich, was den Fehler bei der Bestimmung von Defokussierung und Astigmatismus klein hält. In den Figuren 3b (mittlerer Astigmatismus) und 3c (geringer Astigmatismus) weichen einige Teilbilder von der Kreisform ab, um dieser Forderung zu genügen.

In Figur 3d (kein Astigmatismus) müssen alle Teilbilder von der Kreisringform abweichen. Innerhalb eines jeden kreisringförmigen Teilbilds wäre das Nutzsignal ansonsten konstant, so dass sich keine Information über die Defokussierung gewinnen ließe. In diesem Ausführungsbeispiel haben die Teilbilder eine um eine Kreisringlinie herum periodisch modulierte Form. Diese Form wurde adaptiv bestimmt, indem die Linienkrümmung so lange variiert wurde, bis die Variation des Nutzsignals einen vorgegebenen Schwellwert überschritt.

Generell sollten die Abweichungen der Teilbilder von der Kreisringform nur so groß gewählt werden, dass das Nutzsignal auf diesen Bereichen stark genug variiert, um vom Rauschen unterschieden werden zu können. Je geringer sie gewählt werden, desto besser werden die additiven und multiplikativen Störungen unterdrückt.

Das Gesamtergebnis F der Ähnlichkeit zwischen experimentell gemessenem und simuliertem Bild kann aus den Einzelergebnissen $f_p$ für einen Satz p zum Vergleich herangezogener Bildbereiche beispielsweise nach der Formel

$$F = \sum_{p} w_p f_p$$

errechnet werden, worin die $w_p$ Gewichtungsfaktoren sind.

Statt den in den Figuren gezeigten Diffraktogrammen können auch Rhonchigramme ausgewertet werden, die in Teilbereichen ebenfalls Thon-Ringe enthalten. Statt des in Figur 1 genutzten Transmissionselektronenmikroskops kann auch ein Rastertransmissionselektronenmikroskop (STEM) verwendet werden.

Zur Durchführung des Verfahrens eignet sich insbesondere ein auf einem Computer ablaufendes Computerprogramm.

**Patentansprüche**

1. Verfahren zur Messung der Ähnlichkeit zweier zweidimensionaler, aus Intensitätswerte tragenden Pixeln zusammengesetzter Bilder, wobei zumindest ein Bild neben dem Nutzsignal, das für den Vergleich herangezogen werden soll, ein Zusatzsignal enthält, welches die Ähnlichkeitsmessung erschwert und/oder verfälscht, wobei zumindest die Richtung des Gradienten des Zusatzsignals im Bild abschätzbar ist, mit den Schritten:

   - die Bilder werden derart in wechselseitig identische Teilbilder partitioniert, dass die Ausdehnung mindestens eines Teilbilds in Richtung des Gradienten des Zusatzsignals kleiner ist als die Ausdehnung dieses Teilbilds in der dazu senkrechten Richtung, so dass sich in dem Teilbild das Nutzsignal charakteristisch und eindeutig erkennbar ändert, während sich zugleich das Zusatzsignal nur schwach ändert, wobei die Teilbilder insbesondere linienförmig oder ringförmig sein können;
   - wechselseitig zusammengehörende Teilbilder werden miteinander verglichen;
   - die Ergebnisse dieser Vergleiche werden zu einem Gesamtmaß für die Ähnlichkeit der beiden Bilder zusammengeführt.

2. Verfahren nach Anspruch 1, **gekennzeichnet durch** ein Zusatzsignal, das in Polarkoordinaten stärker vom Radius abhängt als vom Azimut.

3. Verfahren nach einem der Ansprüche 1 bis 2, **dadurch gekennzeichnet, dass** mindestens eine elektronenmikroskopische Aufnahme als Bild gewählt wird und ein Zusatzsignal enthält, das aus mindestens einer der folgenden Quellen stammt:

   - Streufunktion der Atome im betrachteten Objekt;
   - mit der Objektdicke zusammenhängende kinematische Einhüllende;
   - durch teilweise zeitliche oder räumliche Kohärenz bedingte dämpfende Einhüllende;
   - Modulationsübertragungsfunktion des für die Bildaufnahme verwendeten Detektors;
   - statistisches Rauschen mit in vorhersehbarer Weise ortsabhängigem Zeitmittelwert.

4. Verfahren nach einem der Ansprüche 1 bis 3, **dadurch gekennzeichnet, dass** die Vereinigungsmenge aller Teilbilder einen Anteil von mindestens 80 Prozent, insbesondere von mindestens 90 Prozent aller Pixel umfasst.

5. Verfahren nach einem der Ansprüche 1 bis 4, **dadurch gekennzeichnet, dass** ein experimentell gemessenes Bild und ein simuliertes Bild als Bilder gewählt werden, wobei insbesondere Teilbilder gewählt werden, auf denen die Intensitätswerte des simulierten Bildes mindestens über eine vorgegebene Schwankungsbreite variieren.

6. Verfahren nach Anspruch 5, **dadurch gekennzeichnet, dass** aus dem Messergebnis ein neues simuliertes Bild ermittelt wird, welches zum experimentell gemessenen Bild ähnlicher ist als das ursprüngliche simulierte Bild.

7. Verfahren nach Anspruch 6, **dadurch gekennzeichnet, dass** ein Elektronenmikroskop für die Gewinnung des experimentell gemessenen Bildes gewählt wird, wobei mindestens die Parameter Defokussierung und Astigmatismus für die Generierung des simulierten Bildes herangezogen werden und/oder wobei aus der gemessenen Ähnlichkeit Aberrationen des Elektronenmikroskops bestimmt werden.

**8.** Verfahren nach Anspruch 7, wobei aus der gemessenen Ähnlichkeit Aberrationen des Elektronenmikroskops bestimmt werden, **dadurch gekennzeichnet, dass** das Elektronenmikroskop auf eine Korrektur der bestimmten Aberrationen eingestellt und das Verfahren anschließend neu gestartet wird.

**9.** Verfahren nach einem der Ansprüche 5-8, **dadurch gekennzeichnet, dass** das simulierte Bild vor der Partitionierung durch einen Schnellvergleich mit dem experimentell gemessenen Bild ausgewählt wird.

**10.** Verfahren nach Anspruch 9, **dadurch gekennzeichnet, dass** die Intensitätswerte der Pixel mindestens eines der Bilder für den Schnellvergleich auf 16 oder weniger, insbesondere auf zwei, möglicher Werte pro Pixel diskretisiert werden, wobei insbesondere für den Schnellvergleich mit dem diskretisierten Bild eine logische Verknüpfung, insbesondere das ausschließliche Oder (XOR), gewählt wird.

**11.** Verfahren nach einem der Ansprüche 9 bis 10, **dadurch gekennzeichnet, dass** das simulierte Bild aus einem vorberechneten Katalog ausgewählt wird.

**12.** Elektronenmikroskop, umfassend einen digitalen Bildsensor, eine Vorrichtung zur Verkippung des Elektronenstrahls gegenüber dem zu untersuchenden Objekt, eine Linsenanordnung zur Korrektur von Aberrationen sowie einer Steuereinheit für diese Linsenanordnung, **gekennzeichnet durch**
eine Justiervorrichtung für die Linsenanordnung umfassend

- eine Simulationseinheit, die ideale elektronenmikroskopische Bilder von Teststrukturen mit vorgegebenen Werten für deren Defokussierung und Astigmatismus zu liefern vermag;
- eine mit dem Bildsensor und der Simulationseinheit verbundene Vergleichseinheit, die die Ähnlichkeit zwischen einem vom Bildsensor und einem von der Simulationseinheit gelieferten Bild zu messen vermag, mit Mitteln für eine derartige Partitionierung des vom Bildsensor gelieferten und des von der Simulationseinheit gelieferten idealen Bildes in wechselseitig identische Teilbilder, dass die Ausdehnung mindestens eines Teilbilds in Richtung des Gradienten eines in mindestens einem der Bilder vorhandenen Zusatzsignals kleiner ist als die Ausdehnung dieses Teilbilds in der dazu senkrechten Richtung, so dass sich in dem Teilbild das Nutzsignal charakteristisch und eindeutig erkennbar ändert, während sich zugleich das Zusatzsignal nur schwach ändert; und
- eine mit der Vergleichseinheit und der Steuereinheit verbundene Auswerteeinheit, die aus der gemessenen Ähnlichkeit sowie den dazugehörigen Werten für Defokussierung und Astigmatismus die Aberrationen des Elektronenmikroskops näherungsweise zu bestimmen und diese in einen Stellbefehl für die Steuereinheit umzusetzen vermag,

wobei das im Bild neben dem Nutzsignal, das für den Vergleich herangezogen werden soll, vorhandene Zusatzsignal von einer Art ist, dass es die Ähnlichkeitsmessung erschwert und/oder verfälscht, jedoch zumindest die Richtung seines Gradienten im Bild abschätzbar ist.

**13.** Elektronenmikroskop nach Anspruch 12, **gekennzeichnet durch** eine Vergleichseinheit, die ein Verfahren nach einem der Ansprüche 1 bis 11 durchzuführen vermag.

**14.** Elektronenmikroskop nach einem der Ansprüche 12 bis 13, **gekennzeichnet durch** eine Vergleichseinheit umfassend Mittel für eine Diskretisierung der Intensitätswerte der Pixel mindestens eines Bildes auf 16 oder weniger, insbesondere auf zwei, mögliche Werte pro Pixel, insbesondere eine Vergleichseinheit umfassend Mittel für eine ausschließliche Oder-Verknüpfung (XOR) zwischen zwei diskretisierten Bildern.

**15.** Elektronenmikroskop nach einem der Ansprüche 12 bis 14, **gekennzeichnet durch** eine Vergleichseinheit umfassend einen digitalen Signalprozessor (DSP) und/oder eine Justiereinheit umfassend mindestens einen Computer mit einem Computerprogramm oder ein Embedded-System als Computer mit einem Computerprogramm.

**Claims**

**1.** Method of measuring the similarity of two two-dimensional images composed of pixels having intensity values, wherein at least one image contains not only the useful single to be used for the comparison, but also an additional signal which renders the similarity measurement more difficult and/or distorts it, and wherein at least the direction of the gradient of the additional signal in the image can be estimated, comprising the following steps:

- partitioning the images into mutually identical sub-images in such a manner that the extension of at least one sub-image in the direction of the gradient of the additional signal is smaller than the extension of this sub-image in the direction perpendicular thereto, such that the useful signal changes in a characteristic and clearly discernible manner in the sub-image, while the additional signal changes only slightly, wherein the sub-images may be, in particular, linear or annular;
- comparing mutually associated sub-images with one another, and
- combining the results of these comparisons to give an overall measure of the similarity of the two images.

2. Method according to claim 1, **characterised by** an additional signal more dependent on the radius than on the azimuth in polar coordinates.

3. Method according to one of claims 1 to 2, **characterised in that** at least one electron micrograph is selected as the image and contains an additional signal originating from at least one of the following sources:

- scattering function of the atoms in the object being viewed;
- kinematic envelope associated with the thickness of the object;
- damping envelope due to partial temporal or spatial coherence;
- modulation transmission function of the detector used for imaging, or
- random noise with a mean time value location-dependent in a predictable manner.

4. Method according to one of claims 1 to 3, **characterised in that** the union of all of the sub-images contains at least 80 per cent, in particular at least 90 per cent, of all of the pixels.

5. Method according to one of claims 1 to 4, **characterised in that** an experimentally measured image and a simulated image are selected as the images, in particular, sub-images in which the intensity values of the simulated image vary at least over a predetermined range of variation being selected.

6. Method according to claim 5, **characterised in that** a new simulated image more similar to the experimentally measured image than to the original simulated image is determined from the measurement result.

7. Method according to claim 6, **characterised in that** an electron microscope is selected to acquire the experimentally measured image, at least the parameters of defocusing and astigmatism being used to generate the stimulated image and/or aberrations of the electron microscope being determined from the measured similarity.

8. Method according to claim 7, in which aberrations of the electron microscope are determined from the measured similarity, **characterised in that** the electron microscope is adjusted to correct the determined aberrations and the method is then re-started.

9. Method according to one of claims 5-8, **characterised in that** the simulated image is selected before the partitioning operation by quick comparison with the experimentally measured image.

10. Method according to claim 9, **characterised in that** the intensity values of the pixels of at least one of the images are discretised to 16 or fewer, in particular to two, possible values per pixel for the quick comparison, in particular, a logic operation, in particular the exclusive OR (XOR), being selected for the quick comparison with the discretised image.

11. Method according to one of claims 9 to 10, **characterised in that** the simulated image is selected from a pre-computed catalogue.

12. Electron microscope, comprising a digital image sensor, a device for tilting the electron beam relative to the object to be examined, a lens arrangement for correcting aberrations and a control unit for this lens arrangement, **characterised by**
an adjusting device for the lens arrangement, comprising

- a simulation unit capable of delivering ideal electron-microscopic images of test structures having predetermined values for the defocusing and astigmatism thereof;
- a comparison unit connected to the image sensor and to the simulation unit and capable of measuring the similarity between an image delivered by the image sensor and an image delivered by the simulation unit, with means for partitioning the image delivered by the image sensor and the ideal image delivered by the simulation unit into mutually identical sub-images in such a manner that the extension of at least one sub-image in the direction of the gradient of an additional signal present in at least one of the images is smaller than the extension of this sub-image in the direction perpendicular thereto, such that the useful signal changes in a characteristic and clearly discernible manner in the sub-image, while the additional signal changes only slightly, and

- an evaluation unit connected to the comparison unit and to the control unit and capable of approximately determining the aberrations of the electron microscope from the measured similarity and from the associated defocusing and astigmatism values and converting these into a control command for the control unit,

wherein the additional signal present in the image in addition to the useful single to be used for the comparison is of such a nature that it renders the similarity measurement more difficult and/or distorts it, but at least the direction of its gradient in the image can be estimated.

**13.** Electron microscope according to claim 12, **characterised by** a comparison unit capable of carrying out a method according to one of claims 1 to 11.

**14.** Electron microscope according to one of claims 12 to 13, **characterised by** a comparison unit comprising means for discretising the intensity values of the pixels of at least one image to 16 or fewer, in particular to two, possible values per pixel, in particular a comparison unit comprising means for an exclusive OR operation (XOR) between two discretised images.

**15.** Electron microscope according to one of claims 12 to 14, **characterised by** a comparison unit comprising a digital signal processor (DSP) and/or an adjusting unit comprising at least one computer with a computer program or an embedded system as a computer with a computer program.

## Revendications

**1.** Procédé pour mesurer la similitude de deux images en deux dimensions se composant de pixels portant des valeurs d'intensité, au moins une image comprenant, en plus du signal utile qui doit être pris en compte pour la comparaison, un signal supplémentaire qui rend plus difficile et/ou altère la mesure de la similitude, au moins la direction du gradient du signal supplémentaire pouvant être évaluée dans l'image, avec les étapes suivantes :

- les images sont partitionnées en images partielles mutuellement identiques de manière à ce que l'extension d'au moins une image partielle en direction du gradient du signal supplémentaire soit inférieure à l'extension de cette image partielle dans la direction qui lui est perpendiculaire, de sorte que le signal utile dans l'image partielle varie de manière caractéristique et clairement identifiable, alors que simultanément le signal supplémentaire ne varie que faiblement, les images partielles pouvant en particulier être en forme de lignes ou d'anneaux ;
- des images partielles mutuellement apparentées étant comparées entre elles ;
- les résultats de ces comparaisons étant regroupés en une mesure globale pour la similitude des deux images.

**2.** Procédé selon la revendication 1, **caractérisé par** un signal supplémentaire, lequel dépend davantage du rayon que de l'azimut concernant les coordonnées polaires.

**3.** Procédé selon l'une des revendications 1 à 2, **caractérisé en ce que** au moins une microphotographie électronique est choisie en tant qu'image et contient un signal supplémentaire, lequel provient de l'une au moins des sources suivantes :

- fonction de dispersion des atomes dans l'objet observé ;
- extrémité d'enveloppement cinématique en rapport avec l'épaisseur de l'objet ;
- extrémité d'enveloppement amortissante conditionnée par une cohérence en partie temporelle ou spatiale ;
- fonction de transmission des modulations du détecteur utilisé pour l'enregistrement de l'image ;
- bruit statique avec un temps moyen prévisible en fonction du lieu.

**4.** Procédé selon l'une des revendications 1 à 3, **caractérisé en ce que** la quantité de regroupement de toutes les images partielles comprend un pourcentage d'au moins 80 pour cent, en particulier d'au moins 90 pour cent de tous les pixels.

5. Procédé selon l'une quelconque des revendications 1 à 4, **caractérisé en ce qu'**une image mesurée de manière expérimentale et une image simulée sont choisies en tant qu'images, des images partielles étant en particulier choisies, sur lesquelles les valeurs d'intensité de l'image simulée varient au moins selon une amplitude de variation prédéfinie.

6. Procédé selon la revendication 5, **caractérisé en ce que** l'on détermine à partir du résultat de mesure une nouvelle image simulée, laquelle présente davantage de similitude avec l'image mesurée expérimentalement que l'image simulée à l'origine.

7. Procédé selon la revendication 6, **caractérisé en ce que** l'on choisit un microscope électronique pour l'obtention de l'image mesurée expérimentalement, au moins les paramètres de défocalisation et d'astigmatisme étant pris en compte pour la génération de l'image simulée et/ou des aberrations du microscope électronique étant déterminées à partir de la similitude mesurée.

8. Procédé selon la revendication 7, des aberrations du microscope électronique étant déterminées à partir de la similitude mesurée, **caractérisé en ce que** le microscope électronique est réglé pour une correction des aberrations déterminées et **en ce que** le procédé est ensuite relancé.

9. Procédé selon l'une des revendications 5-8, **caractérisé en ce que** l'image simulée est sélectionnée avant le partitionnement grâce à une comparaison rapide avec l'image mesurée expérimentalement.

10. Procédé selon la revendication 9, **caractérisé en ce que** les valeurs d'intensité des pixels de l'une au moins des images sont discrétisées pour une comparaison rapide à 16 ou moins, en particulier à deux valeurs possibles par pixel, moyennant quoi on sélectionne en particulier pour la comparaison rapide avec l'image discrétisée une opération logique, en particulier le OU exclusif (XOR).

11. Procédé selon l'une des revendications 9 à 10, **caractérisé en ce que** l'image simulée est sélectionnée à partir d'un catalogue calculé à l'avance.

12. Microscope électronique, comprenant un capteur d'image numérique, un dispositif pour le culbutage du faisceau d'électrons par rapport à l'objet analysé, un réseau de lentilles pour la correction d'aberrations ainsi qu'une unité de commande pour ce réseau de lentilles, **caractérisé par**
un dispositif de réglage pour le réseau de lentilles, comprenant :

   - une unité de simulation, laquelle est en mesure de délivrer les images de microphotographie électronique idéales de structures de test avec des valeurs prédéfinies pour la défocalisation et l'astigmatisme de celles-ci ;
   - une unité de comparaison en liaison avec le capteur d'image et l'unité de simulation, laquelle est en mesure de mesurer la similitude entre une image délivrée par le capteur d'image et une image délivrée par l'unité de simulation, avec des moyens pour un tel partitionnement de l'image idéale délivrée par le capteur d'image et par l'unité de simulation en images partielles mutuellement identiques, de sorte que l'extension de l'une au moins des images partielles en direction du gradient d'un signal supplémentaire existant dans l'une au moins des images est inférieure à l'extension de cette image partielle dans la direction qui lui est perpendiculaire, de sorte que le signal utile dans l'image partielle varie de manière caractéristique et clairement identifiable, alors que simultanément le signal supplémentaire ne varie que faiblement ; et
   - une unité d'évaluation en liaison avec l'unité de comparaison et l'unité de commande, laquelle est en mesure de déterminer approximativement, à partir de la similitude mesurée ainsi que des valeurs qui y sont associées pour la défocalisation et l'astigmatisme, les aberrations du microscope électronique, et de transformer celles-ci en une commande de positionnement pour l'unité de commande,

le signal supplémentaire existant dans l'image en plus du signal utile devant être pris en compte pour la comparaison étant d'un genre à rendre plus difficile et/ou à altérer la mesure de la similitude, au moins la direction de son gradient pouvant cependant être évaluée dans l'image.

13. Microscope électronique selon la revendication 12, **caractérisé par** une unité de comparaison, laquelle est en mesure de réaliser un procédé selon l'une des revendications 1 à 11.

14. Microscope électronique selon l'une des revendications 12 à 13, **caractérisé par** une unité de comparaison comprenant des moyens pour une discrétisation des valeurs d'intensité des pixels d'au moins une image à 16 ou moins, en particulier à deux valeurs possibles par pixel, en particulier une unité de comparaison comprenant des moyens pour une opération logique exclusive OU (XOR) entre deux images discrétisées.

15. Microscope électronique selon l'une des revendications 12 à 14, **caractérisé par** une unité de comparaison comprenant un processeur de traitement de signaux numériques (DSP) et/ou une unité de réglage comprenant au moins un ordinateur avec un programme informatique ou un système intégré en tant qu'ordinateur avec un programme informatique.

Figur 1

Figur 2a

Figur 2b

Figur 2c

Figur 3a

Figur 3b

Figur 3c

Figur 3d

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **F. ZEMLIN et al.** Coma-free alignment of high resolution electron microscopes with the aid of optical diffractograms. *Ultramicroscopy,* 1978, vol. 3, 49-60
- **S. UHLEMANN ; M. HAIDER.** Residual wave aberrations in the first spherical aberration corrected transmission electron microscope. *Ultramicroscopy,* 1998, vol. 72, 109-119
- **A. THUST et al.** Numerical correction of lens aberrations in phase-retrieval HRTEM. *Ultramicroscopy,* 1996, vol. 64, 249-264
- **JOHANNES ZEMLIN ; FRIEDRICH ZEMLIN.** Diffractogram tableaux by mouse click. *Ultramicroscopy,* 2002, vol. 93, 77-82